# DEMANDE DE BREVET EUROPEEN

(11) **EP 1 736 435 A1**
(43) Date de publication de la demande: **27.12.2006**
(21) Numéro de dépôt: 06115813.5
(22) Date de dépôt: 21.06.2006
(51) Int. Cl.: B81B 3/00, G02B 26/08

(54) **Actionneur électrostatique comprenant un pivot conducteur suspendu**

(30) Priorité: 23.06.2005 FR 0551733
(71) Demandeur: COMMISSARIAT A L'ENERGIE ATOMIQUE, 75015 Paris (FR)
(72) Inventeur: Chappaz, Cédrick, 38920, CROLLES (FR); Divoux, Claire, VANCOUVER British Columbia V6R2L2 (CA)
(74) Mandataire: Poulin, Gérard

(57) **Abrégé**

La présente invention se rapporte principalement à :
- un actionneur électrostatique,
- au moins une électrode fixe (2) par rapport à un substrat (4),
- au moins une électrode souple (6) disposée en regard du substrat,
- au moins un moyen formant pivot de l'électrode souple, ledit moyen étant solidaire de l'électrode souple sur sa face orientée vers l'électrode fixe (2) et réalisé en un matériau conducteur,
- au moins un moyen de suspension (11) de l'électrode souple, maintenant au repos ladite électrode souple à distance du substrat (4).

La présente invention a également pour objet un procédé de réalisation d'un tel actionneur.

## Description

### DOMAINE TECHNIQUE ET ART ANTÉRIEUR

La présente invention se rapporte à des systèmes de type MEMS (Micro-Electro-Mécaniques). Plus particulièrement, l'invention se rapporte à un actionneur électrostatique utilisé dans ce type de système, à des dispositifs comportant un tel actionneur et à un procédé de réalisation d'un tel actionneur.

On appelle actionnement de type "zipping", ou « à fermeture progressive ou par glissière», un actionnement électrostatique particulier, pour lequel une électrode mobile vient accoster ou est plaquée le long d'un isolant la séparant d'une électrode fixe, ce mouvement se faisant progressivement et presque linéairement avec la tension appliquée.

Des dispositifs connus, fonctionnant sur ce principe, sont décrits dans l'article de J. Gravesen et al. « A New Electrostatic Actuator providing improved Stroke length and Force », MEMS'92 ou dans le document WO 92/22763.

Ces dispositifs permettent des déplacements autour d'un axe de rotation, ou le long d'un axe de translation.

De plus, ce type de dispositif nécessite des tensions de plusieurs dizaines de volts pour des rotations de quelques degrés.

Du document US 2002/0135850, est connu un dispositif permettant des déplacements ayant une amplitude augmentée par rapport aux autres dispositifs. Pour cela le dispositif est formé d'une succession d'actionneurs de type connu, qui en fonctionnement amplifie le déplacement initial. Ce type de dispositif est relativement complexe.

Il existe également des actionneurs électrostatiques comportant un moyen formant pivot pour l'électrode souple, ce pivot étant fixe par rapport à une électrode fixe, ce qui autorise alors un déplacement vertical pour l'extrémité libre de l'électrode souple et amplifie le déplacement. Cependant ce dispositif ne permet pas d'obtenir différents types de déplacement avec un seul actionneur. De plus, la tension d'actionnement de tels actionneur est sensiblement la même que des actionneurs sans pivot.

C'est par conséquent un but de la présente invention d'offrir un actionneur électrostatique permettant à la fois de réaliser des déplacements dans toutes les directions et également d'obtenir un déplacement important, et de tension d'actionnement faible.

### EXPOSÉ DE L'INVENTION

Le but précédemment énoncé est atteint par un actionneur comportant une électrode souple, une électrode fixe par rapport au substrat et un moyen formant pivot de l'électrode souple, le moyen formant pivot étant solidaire de l'électrode souple et réalisé en matériau conducteur. L'électrode souple comporte également des moyens de suspension de ladite électrode par rapport au substrat. La distance entre l'électrode fixe et le pivot étant plus faible que la distance entre l'électrode fixe et l'électrode mobile, la tension d'actionnement est réduite.

La présente invention a alors principalement pour objet un actionneur électrostatique comportant :
- au moins une électrode fixe par rapport à un substrat,
- au moins une électrode souple disposée en regard du substrat,
- au moins un moyen formant pivot de l'électrode souple, ledit moyen étant solidaire de l'électrode souple sur sa face orientée vers l'électrode fixe,
- au moins un moyen de suspension de l'électrode souple, maintenant au repos ladite électrode souple à distance du substrat.

Avantageusement, le moyen de suspension est formé par une poutre de suspension fixée par une extrémité à un support en saillie du substrat.

Dans une réalisation particulière, le moyen formant pivot a la forme d'un plot.

Dans un mode particulier, une face de l'électrode souple opposée à la face en regard de l'électrode fixe, est destinée à supporter un objet à déplacer.

De manière préférée, l'électrode souple et/ou l'électrode fixe sont recouvertes d'une couche de matériau diélectrique.

Par exemple, l'actionneur peut comporter deux électrodes fixes et deux moyens formant pivot, chacune des électrodes fixes étant disposée entre une extrémité de l'électrode souple et un moyen formant pivot.

En outre, l'invention a également pour objet un dispositif d'actionnement électrostatique, comportant un premier et un deuxième actionneurs selon la présente invention.

Dans un mode particulier, les électrodes souples des deux actionneurs sont suspendues respectivement par le moyen de suspension associé, à un support commun, en saillie du substrat.

Dans un autre mode particulier, le dispositif d'actionnement électrostatique comporte au moins un actionneur du premier type selon l'invention, et au moins un actionneur d'un deuxième type comportant une électrode fixe et une électrode souple maintenue à distance de l'électrode fixe, lesdits actionneurs étant répartis angulairement de manière régulière.

Avantageusement, les moyens de suspension sont répartis angulairement de manière régulière entre les actionneurs.

Par exemple, le dispositif comporte trois actionneurs du premier type et trois actionneurs du deuxième type disposés alternativement. Les moyens de suspension peuvent être au nombre de trois, répartis angulairement de manière régulière, à angle égal entre un actionneur du premier type et un actionneur du deuxième type.

Avantageusement, les électrodes souples des actionneurs du premier et deuxième type s'étendent de leur première à leur deuxième extrémités en zigzag.

Dans un autre mode particulier, les actionneurs du premier et deuxième types sont disposés de part et d'autre d'un axe fixé par une extrémité à l'objet à déplacer et formant un moyen de suspension.

Dans ce mode particulier, le dispositif peut comporter de part et d'autre de l'axe, une pluralité d'actionneurs du premier et deuxième types, disposés alternativement parallèlement les uns par rapport aux autres.

Par exemple,les actionneurs adjacents du premier et du deuxième types, sont portés par les branches d'un U, un U disposé d'un côté de l'axe étant raccordé à un U disposé de l'autre côté de l'axe par une branche centrale fixée à l'axe et raccordant les fonds des U.

Le dispositif peut comporter au moins deux axes, avantageusement six répartis angulairement de manière régulière autour de l'objet à déplacer.

De manière avantageuse, les électrodes souples sont munies de zones d'amorce de manière à faciliter le collage des électrodes souples sur le substrat.

La présente invention a également pour objet un microsystème comportant un objet à déplacer et un dispositif d'actionnement électrostatique selon l'invention, l'objet à déplacer étant par exemple un miroir.

La présente invention a également pour objet un procédé de réalisation d'un actionneur électrostatique selon l'invention sur un substrat comportant les étapes :
a) de réalisation d'au moins une électrode fixe en face avant du substrat,
b) de dépôt d'une couche sacrificielle,
c) de structuration de ladite couche sacrificielle pour former au moins une électrode souple, au moins un moyen de suspension et au moins un moyen formant pivot,
d) de dépôt d une couche conductrice et d'élimination de la couche sacrificielle.

Avantageusement, de manière préalable à la formation de l'électrode fixe, une couche d'oxyde, par exemple de l'oxyde de silicium, est déposée en face avant du substrat.

Lors de l'étape a), une couche métallique est déposée sur la couche d'oxyde, celle-ci étant ensuite structurée par lithographie et gravée.

De manière préférée, un dépôt d'une couche de matériau diélectrique a lieu après la gravure de la couche métallique.

En outre, l'étape c) peut être réalisée par double lithographie et gravure de la couche sacrificielle. A la fin de l'étape c), la couche sacrificielle comporte des canaux traversant, atteignant la couche isolante pour la connexion entre le substrat et l'électrode souple et au moins un canal non traversant pour la formation du moyen formant pivot.

### BRÈVE DESCRIPTION DES DESSINS

La présente invention sera mieux comprise à l'aide de la description qui va suivre et des dessins en annexes, et sur lesquels :

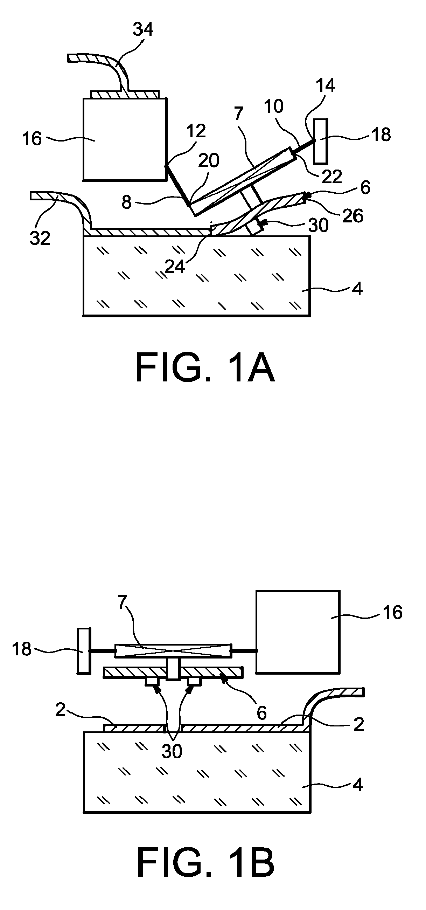

- la figure 1A est une vue schématique d'un premier exemple d'un actionneur selon la présente invention dans une première position activée,

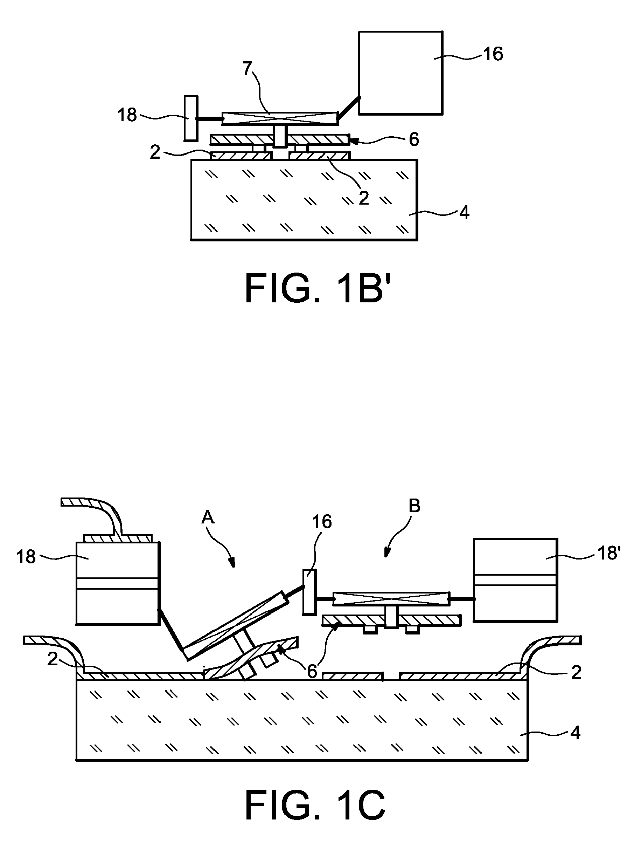

- la figure 1B est une vue schématique d'un deuxième exemple d'un actionneur selon la présente invention en position repos,
- la figure 1B' est une vue schématique de l'actionneur de la figure 1B dans une position activée,
- la figure 1C est une vue schématique d'un premier mode de réalisation d'un dispositif selon la présente invention en partie activé,
- la figure 2A est une vue de dessus d'un premier exemple d'un dispositif selon un deuxième mode de réalisation,
- la figure 2B est une vue de dessus d'un deuxième exemple d'un dispositif selon le deuxième mode de réalisation,
- la figure 3 est une vue de dessus d'un troisième mode de réalisation d'un dispositif d'actionnement selon la présente invention,
- la figure 3A est une vue d'un détail de la figure 3,
- les figures 4A à 4K représentent des étapes d'un procédé selon l'invention,
- la figure 5 est une vue de détail d'un actionneur selon la présente invention,
- la figure 6 est une représentation graphique de l'évolution du déplacement d'une électrode souple en fonction de la tension appliquée pour des électrodes de longueur différente.

### EXPOSÉ DÉTAILLÉ DE MODES DE RÉALISATION PARTICULIERS

Sur la figure 1A, on peut voir un exemple de réalisation d'un actionneur selon la présente invention comportant une électrode fixe 2 par rapport à un substrat 4, un électrode souple 6 disposée en regard de l'électrode fixe. Un objet à déplacer 7 est fixé à un face supérieure 9 de l'électrode souple 6.

L'actionneur comporte également des moyens de suspension 11 de l'électrode souple par rapport au substrat. Les moyens 11 sont, dans l'exemple représenté, formés par des première et deuxième poutres de suspension 8,10 attachées par une première extrémité 12,14 à des supports respectifs 16,18 et par une deuxième extrémité 20,22 à l'objet 7, dans l'exemple représenté.

Les poutres 8,10 sont avantageusement disposées de manière coaxiale. En d'autres termes, si l'objet 7 a la forme d'un disque, les poutres sont fixées à l'objet 7 de manière diamétralement opposée.

Les moyens de suspension 11 peuvent comporter une seule poutre ou plus de deux.

Les moyens de suspension peuvent être rectilignes ou incurvées suivant le mode d'actionnement souhaité.

L'électrode souple est alors maintenue à distance de l'électrode fixe de manière sensiblement parallèle à celle-ci.

L'actionneur comporte également un moyen 30 formant pivot de l'électrode souple, solidaire de ladite électrode souple, entre la première 24 et la deuxième 26 extrémités de l'électrode souple 6. L'électrode fixe 2 est disposée en face de la portion de l'électrode mobile 6 située entre la première extrémité 24 et le moyen de pivot 30, de manière à permettre un éloignement de la deuxième extrémité 26 de l'électrode souple du substrat 4, lorsque la première extrémité 24 se rapproche de l'électrode fixe 2. En effet, du fait de l'effet de levier provoqué par le moyen 30, la deuxième extrémité 26 a un déplacement sensiblement vertical vers le haut.

Le moyen formant pivot est réalisé en matériau conducteur, avantageusement le même que celui formant l'électrode souple, lui permettant de participer au déplacement de l'électrode mobile et de réduire la tension d'actionnement de l'électrode souple.

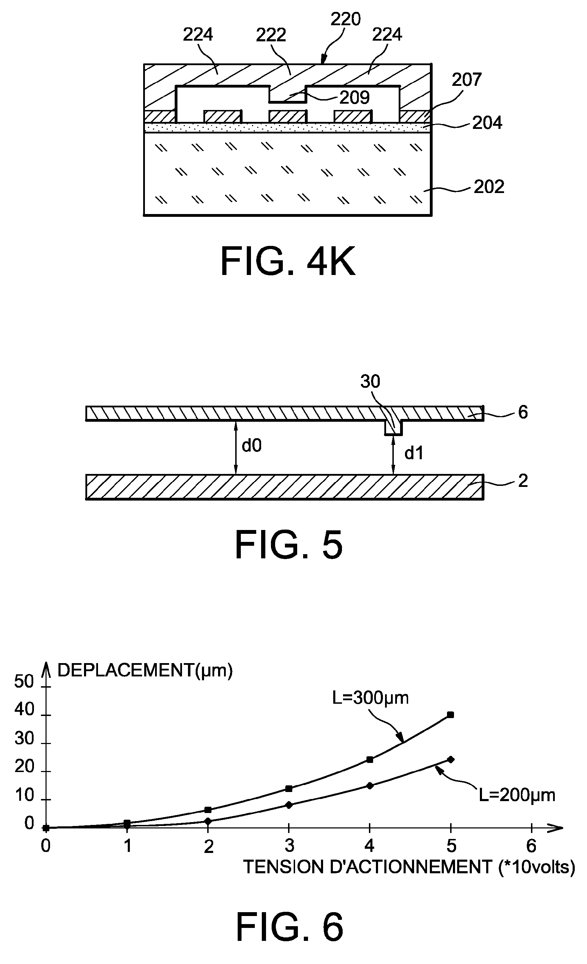

En effet, comme on peut le voir sur la figure 5, la distance d1 séparant une extrémité inférieure du pivot 30 de l'électrode fixe 2 est inférieure à celle d0 séparant l'électrode souple 6 de l'électrode 2 fixe, ainsi la tension de seuil ou d'actionnement est abaissée.

La solidarisation du plot à l'électrode souple présente également l'avantage d'éviter les mouvements de glissement non contrôlés, qui peuvent avoir lieu lorsque le plot est solidaire du substrat. Ainsi, le déplacement de l'électrode souple est mieux maîtrisé.

De manière avantageuse, l'électrode souple et le moyen formant pivot sont réalisés d'un seul tenant.

Dans une variante de réalisation, les moyens de suspension formés des poutres et des supports sont également réalisés d'un seul tenant avec l'électrode souple.

L'électrode souple peut être en forme de zigzag ou tout autre forme permettant d'augmenter la longueur de l'électrode sans en augmenter l'encombrement axial. Cette forme particulière permet de réduire la tension de seuil d'actionnement comme il le sera expliqué dans la suite de la description.

Les poutres de suspension 8,10 peuvent être fixées directement sur l'électrode souple.

Le pivot 30 a la forme d'un plot, par exemple de section parallélépipédique. Mais d'autres formes de plot sont envisageables.

L'utilisation d'un actionneur muni d'un moyen de pivot permet d'obtenir des déplacements importants avec de faibles tensions de travail

Les électrodes fixe et mobile sont reliées à une source de tension par des conducteurs 32,34. Il est également possible de ne faire varier la tension que d'une des deux électrodes 2,6, l'autre électrode 6,2 étant reliée à la masse.

De manière avantageuse, les électrodes fixes et/ou mobiles sont recouvertes d'une couche isolante pour éviter l'apparition de courts-circuits.

L'objet à déplacer 7, est par exemple une charge mécanique, et/ou un contact électrique, et/ou un composant électrique et/ou optique ou encore un miroir et/ou une membrane, pouvant notamment elle-même former un miroir.

Dans le cas d'une membrane, la force de rappel est exercée avantageusement par la membrane en réaction de la force exercée par l'actionneur, alors que dans les actionneurs de type connu, un élément de rappel spécifique est nécessaire.

Nous allons maintenant expliquer le fonctionnement d'un tel actionneur.

Lorsqu'une différence de tension est appliquée entre les électrodes souple 6 et fixe 2, l'électrode souple se déplace en direction du substrat 4, de manière à ce qu'elle vienne en contact du substrat 4, puis pivote autour du moyen formant pivot 30. Ainsi l'actionneur a, à la fois, un déplacement vertical de forte amplitude et en rotation autour du pivot 30.

Sur la figure 1B, l'actionneur comporte deux moyens formant pivot 30 disposés symétriquement de part et d'autre d'un axe médian de l'électrode souple et deux électrodes fixes 2. Ainsi, il est possible d'orienter l'objet 7 autour de deux axes de rotation, parallèles au plan de la feuille et passant par les pivots 30.

Il est également possible de déplacer l'objet 7 parallèlement au plan du substrat. En effet, lorsque les deux extrémités de l'électrode souple 6 sont soumises simultanément à une même différence de tension, par rapport à l'électrode fixe en regard, l'électrode mobile 6 est attirée vers le substrat 4 ou éloignée du substrat 4 en se déplaçant parallèlement au plan du substrat 4 (Figure 1B')

L'objet 7 peut, par conséquent, avoir des déplacements multiples en combinant les déplacements décrits ci-dessus.

Sur la figure 1C, on peut voir un dispositif d'actionnement électrostatique comportant deux actionneurs A,B selon la présente invention. Les deux actionneurs ont la structure décrite ci-dessus. Dans l'exemple représenté, les deux actionneurs sont suspendus par une extrémité à un support respectif 18,18', et par une deuxième extrémité à un support commun 16. Chaque actionneur pourrait avoir des supports distincts. Le mode de fonctionnement de chacun des actionneurs est identique à celui décrit précédemment.

Des moyens d'adressage sont prévus pour commander indépendamment les deux électrodes fixes dans l'exemple de la figure 1B, et les deux actionneurs dans l'exemple de la figure 1C.

Les moyens d'adressage peuvent agir au niveau des électrodes fixes, au niveau des électrodes mobiles ou encore au niveau des électrodes fixes et mobiles. Les électrodes non adressées sont généralement au potentiel de masse.

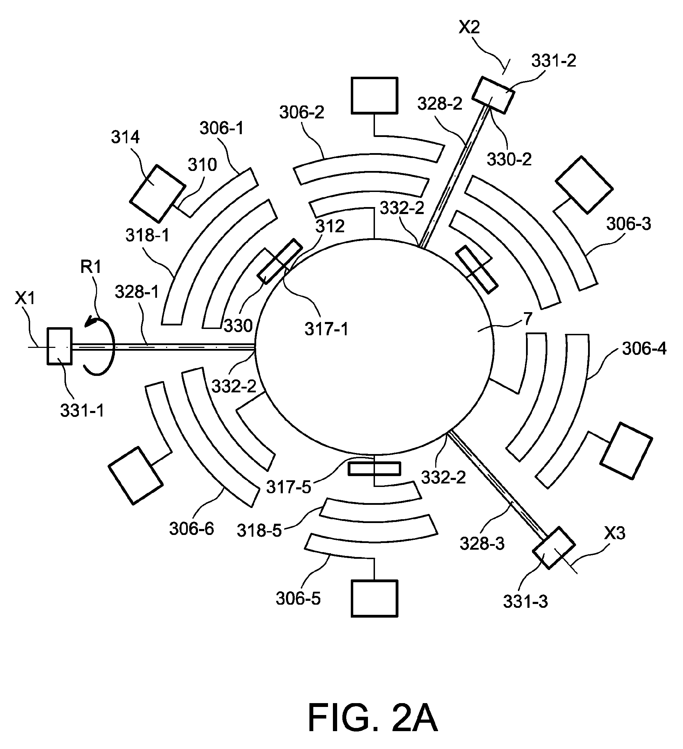

Sur la figure 2A, on peut voir un autre mode de réalisation d'un dispositif d'actionnement électrostatique selon la présente invention, comportant six électrodes souples, le déplacement de chacune des trois électrodes 306.1, 306.3 et 306.5 (les « premières électrodes ») est amplifié par un pivot 330, ce qui n'est pas le cas des autres électrodes 306.2, 306.4, 306.6 (les « deuxièmes électrodes »). Les premières et deuxièmes électrodes sont réparties alternativement et de manière régulière angulairement autour d'un objet 7 à déplacer, par exemple un miroir.

Les premières électrodes étant toutes sensiblement identiques, ainsi que les deuxièmes électrodes, nous nous limiterons à la description de la première électrode 306.1 et de la deuxième électrode 306.2.

L'électrode souple 306.1 est maintenue suspendue par rapport au substrat par une première extrémité 310 fixée à un support 314, et par une deuxième extrémité 312 solidaire de l'objet à déplacer 7.

La première extrémité 310 est munie d'une zone d'amorce pour faciliter le rapprochement de l'électrode souple 306.1 par rapport à une électrode fixe sur le substrat (non représentée) disposée en regard de l'électrode souple 306.1.
le moyen de pivot 330 est intercalé entre l'électrode souple et l'électrode fixe, de manière fixe par rapport à l'électrode souple 306.1, et délimite une zone 318.1 entre le support 314 et le pivot 330 et une zone 317.1 entre le pivot 330 et l'objet 7.

L'électrode souple 306.2 est identique à l'électrode 306.1, par contre aucun moyen de pivot 330 n'est interposé entre l'électrode souple 306.1 et l'électrode fixe.

De manière avantageuse, les électrodes souples 306.1 à 306.6 s'étendent en zigzag entre leurs première 310 et deuxième 312 extrémités respectivement, offrant ainsi plus de souplesse lors de leur déformation, et une meilleure sensibilité de l'actionneur.

De plus, cette forme d'électrode permet de réduire la tension de seuil d'actionnement. En effet, il a été constaté que plus la longueur de l'électrode mobile est importante, plus l'énergie électrostatique emmagasinée est importante, ainsi le collage de l'électrode souple sur l'électrode mobile nécessite une tension plus faible. Sur la figure 6, on peut voir le déplacement d'une électrode de longueur 300 µm et d'une électrode de longueur 200 µm en fonction de la tension, on peut voir que le déplacement de la plus grande électrode est sensiblement plus important que celui de l'électrode de plus petite dimension.

Toute autre forme permettant une augmentation de la longueur sans augmentation de l'encombrement de l'électrode souple peut convenir, par exemple de forme incurvée, en spirale.

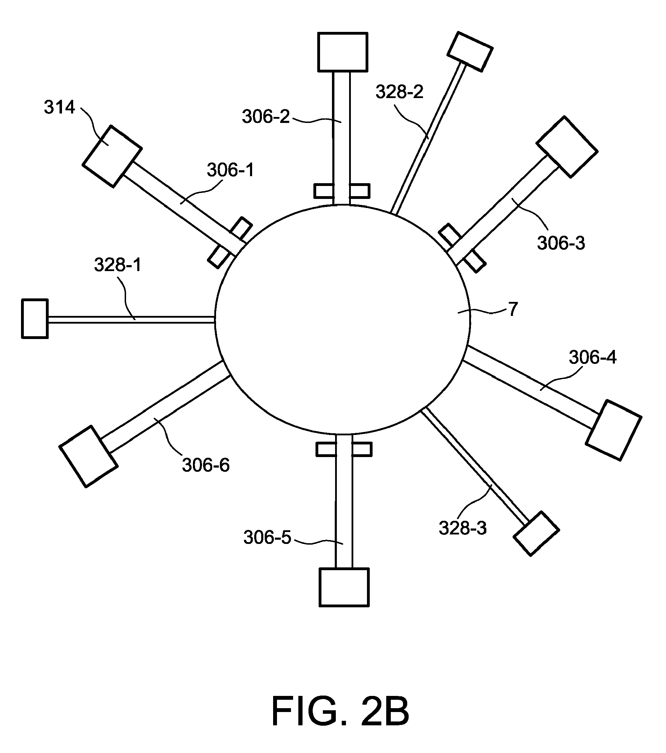

Sur la figure 2B, on peut voir un dispositif d'actionnement électrostatique ayant sensiblement la même structure, que celle du dispositif représenté en figure 2A, cependant les électrodes souples 306.1 à 306.6 sont en forme de languette parallélépipédique.

A titre indicatif, la longueur d'une électrode souple peut être comprise entre 50 µm et 800 µm et avoir, lorsqu'elle est munie d'un plot, un débattement compris entre 1 µm et 10 µm vers le haut.

De manière avantageuse, le dispositif comporte également des bras de suspension 328.1, 328.2, 328.3, (trois bras dans le mode représenté), qui sont attachés par une première extrémité à un support 331.1, 331.2 et 331.3 en saillie du substrat et par une deuxième extrémité 332.1,332.2,332.3 à l'objet 7. Ainsi au repos, ils définissent une position de l'objet.

Avantageusement, chaque bras de suspension est disposé à angle égal entre une électrode souple munie d'un moyen de pivot et une électrode souple sans moyen de pivot.

Les bras de suspension sont avantageusement disposés respectivement orthogonalement aux premiers et aux deuxième actionneurs de manière à former des axes de rotation X1,X2,X3. Ces bras 330.1 à 330.3 sont alors soumis, lors d'un actionnement en rotation à un couple de torsion.

Nous allons maintenant expliquer le fonctionnement d'un tel dispositif.

Lorsqu'une différence de tension, apte à attirer l'électrode souple vers le substrat, est appliquée entre l'électrode souple 306.1 et l'électrode fixe associée (non représentée), la zone 318 se rapproche de l'électrode fixe, provoquant l'éloignement de la portion 317 et de la deuxième extrémité 312 de l'électrode souple 306.1. L'objet 7 est relevé. Lorsqu'une même différence de tension est appliquée entre chaque électrode souple 306.1, 306.3 et 306.5 et son électrode fixe associée, l'objet se déplace selon un axe sensiblement orthogonal au plan du support en éloignement ou en rapprochement du substrat selon le signe de la différence de potentiel.

Lorsqu'une différence de tension, apte à attirer l'électrode mobile 306.2 vers le substrat, est appliquée entre l'électrode souple 306.2 et son électrode fixe associée, l'objet 7 est abaissé. Lorsque une même différence de tension est appliquée entre chaque électrode 306.2, 306.4 et 306.6 et son électrode fixe associée, l'objet a alors un déplacement selon un axe sensiblement orthogonal au plan du support en rapprochement ou en éloignement du substrat en fonction du signe de la différence de tension. Ces déplacements ont une amplitude plus faible, que l'amplitude des déplacements provoqués par l'actionnement des électrodes 306.1, 306.3 et 306.5 soumises à une même différence de potentiel.

Il suffit d'actionner une ou plusieurs des électrodes souples parmi les 306.1 à 306.6 pour obtenir le déplacement souhaité.

Nous allons maintenant considérer les électrodes 306.2 et 306.5.

Lorsqu'une différence de potentiel, apte à attirer l'électrode mobile 306.5, est appliquée entre l'électrode mobile 306.5 et l'électrode fixe associée, et une différence de tension apte à attirer l'électrode 306.2 vers le substrat, est appliquer entre l'électrode 306.2 et l'électrode fixe associée, l'objet 7 pivote autour de l'axe X1 dans le sens de la flèche R1. Le sens de rotation peut être inversé, en inversant les différences de potentiel.

Des moyens d'adressage (non représentés) sont prévus pour activer un ou plusieurs actionneurs.

Les moyens d'adressage peuvent agir au niveau des électrodes fixes, au niveau des électrodes mobiles 306.1, 306.2, 306.3, 306.4, 306.5 et 306.6 ou encore au niveau des électrodes fixes et mobiles. Les électrodes non adressées sont généralement au potentiel de masse.

Si l'adressage s'effectue sur les électrodes fixes, les électrodes mobiles peuvent être réalisées toutes d'un seul tenant, tandis que si l'adressage s'effectue sur les électrodes mobiles, ce sont les électrodes fixes qui peuvent être formées d'une seule pièce.

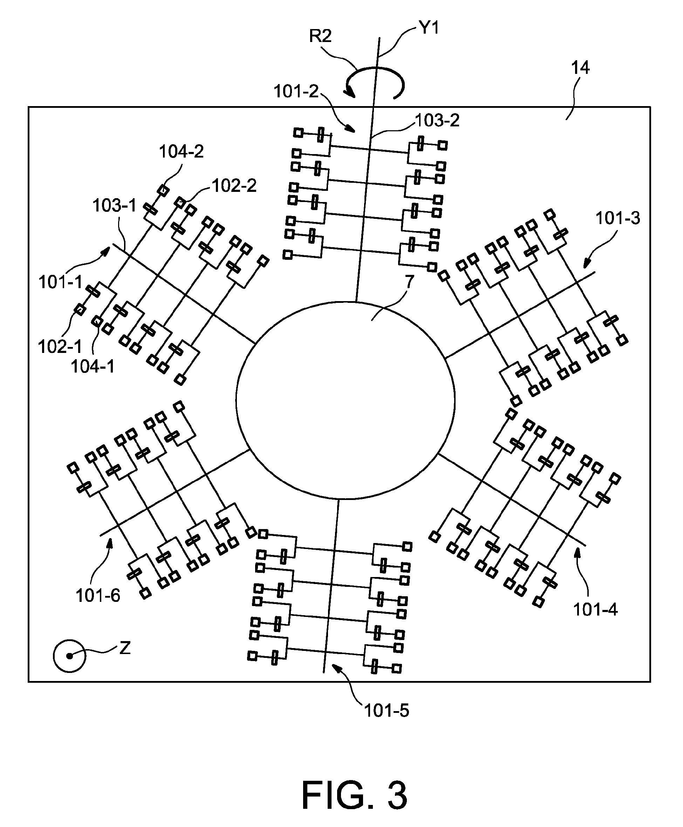

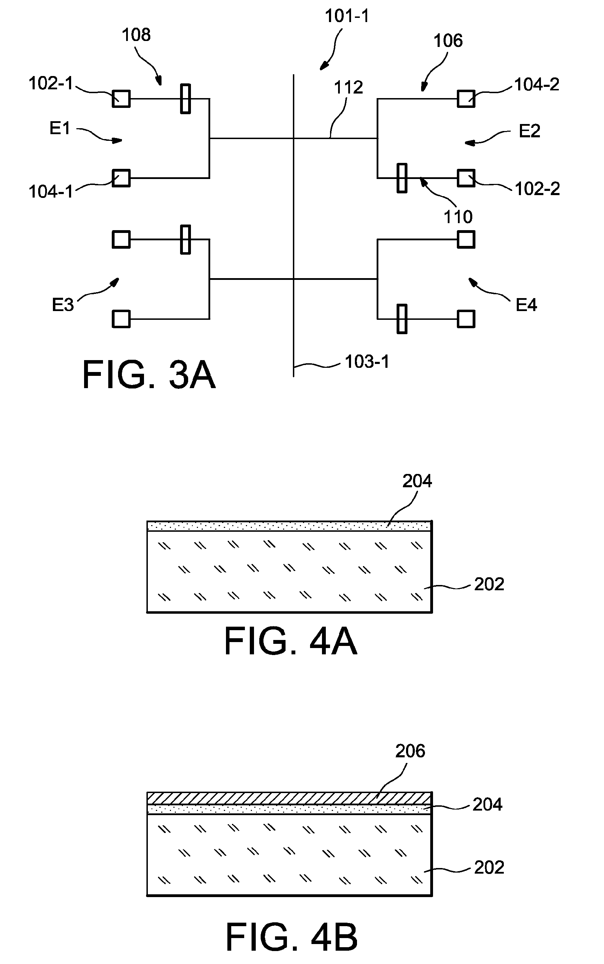

Sur la figure 3, on peut voir un dispositif d'actionnement comportant plusieurs actionneurs selon la présente invention, les actionneurs sont raccordés à l'objet à déplacer par un bras.

Le dispositif selon le troisième mode de réalisation comporte six bras actionneurs 101.1, 101.2, 101.3, 101.4, 101.5, 101.6 répartis angulairement de manière régulière, autour de l'objet à déplacer. Ainsi les bras 101.1-101.4, 101.2-101.5, 101.3-101.6 sont disposés deux à deux de manière diamétralement opposée.

Tous les bras sont, dans le mode de réalisation représenté, sensiblement identiques, par conséquent, nous nous limiterons à la description du bras 101.1.

Le bras 101.1 comporte, disposés de part et d'autre de son axe, des premiers éléments actionneurs 102.1, 102.2 et de deuxièmes éléments actionneurs 104.1,104.2. Le bras 101.1 comporte de chaque côté le même nombre de premiers actionneurs et de deuxièmes actionneurs disposés alternativement parallèlement les uns par rapport aux autres, de manière à ce qu'un premier actionneur se trouve sensiblement en face d'un deuxième actionneur. Ainsi il est possible d'équilibrer l'effort exercé sur un bras et également de favoriser le mouvement. En effet, lorsqu'un des bras 104.2 se déplace vers le haut d'un côté, le bras 102.1 de l'autre côté de l'axe, se déplace vers le bas.

Dans ce mode de réalisation, les électrodes souples sont formées par des languettes sensiblement parallélépipédiques. Dans une variante de réalisation, les actionneurs peuvent comporter des électrodes souples s'étendant en zigzag ou ayant une autre forme, telle que décrites précédemment.

De manière avantageuse, (figure 3a) le bras 101.1 comporte des sous ensembles E1,E2,E3,E4 de quatre actionneurs, reliés à un axe 103.1. Nous nous limiterons à la description du sous ensemble E1. E1 comporte quatre actionneurs 102.1,102.2,104.1,104.2, un premier 102.1,102.2 et un deuxième 104.1,104.2 actionneurs de chaque côté ayant, dans l'exemple représenté, une électrode souple 106 commune. L'électrode 106 est suspendue entre l'axe 103.1 et des supports 114 en saillie du substrat.

Chaque actionneur peut avoir une électrode souple distincte, attachée à l'axe par un support intermédiaire.

L'électrode souple 106 comporte une première partie 108 en forme de U portant les actionneurs 102.1 et 104.1 sur chacune de ses branches et une deuxième partie 110 en U portant les actionneurs 102.2 et 104.2. Une branche centrale 112 solidaire de l'axe 103.1, sensiblement dans sa partie médiane, raccorde les première 108 et les deuxième 110 parties, de manière à ce qu'elles soient avantageusement symétriques par rapport à l'axe 103.1.

Les extrémités libres des U sont raccordées à des supports 114 en saillie du substrat.

Dans ce mode de réalisation, l'adressage s'effectue par les électrodes fixes de manière à permettre une commande individuelle des actionneurs 102.1,102.2,104.1,104.2.

A titre indicatif, la longueur d'un actionneur peut être d'environ 20 µm et la distance séparant deux actionneurs peut être égale à environ 10 µm.

Nous allons maintenant expliquer le fonctionnement du dispositif actionneur selon le troisième mode de réalisation.

Lorsqu'une différence de tension, apte à attirer l'électrode mobile vers le substrat, est appliquée entre les électrodes souples et fixes des premiers actionneurs du bras 101.1, le bras est déplacé en éloignement du support du fait de l'effet levier provoqué par les pivots. L'objet 7 pivote alors autour d'un axe sensiblement orthogonal à l'axe 103.1.

Lorsqu'une même différence de tension est appliquée entre chaque électrode mobile et son électrode fixe associée, tous les premiers actionneurs des six bras actionneurs sont alors activés, l'objet a alors un déplacement selon un axe Z sensiblement orthogonal au plan du support en éloignement ou en rapprochement du support en fonction du signe de la différence de tension.

Nous allons maintenant considérer plus particulièrement les bras 101.2 et 101.5.

Il est possible de provoquer la rotation de l'objet 7 autour de l'axe Y1 passant par les axes 103.2 et 103.5, en actionnant simultanément tous les premiers actionneurs. Les actionneurs disposés d'un même côté des axes 103.2 et 103.5 sont actionnés, de manière à provoquer le même mouvement de l'extrémité de l'électrode souple attachée à l'axe 103.2 et 103.5. Par exemple, les actionneurs disposés du côté gauche des axe 103.2 et 103.5 sur la figure 3, sont actionnés de manière à rapprocher les extrémités des électrodes mobiles du substrat et les actionneurs disposés du côté droit des axes 103.2 et 103.5 sur la figure 3, sont actionnés de manière à éloigner les extrémités des électrodes souples attachées aux axes 103.2, 103.5 du substrat. L'objet 7 tourne alors dans la direction indiquée par la flèche R2.

Le sens de rotation peut être inversé en modifiant les différences de tension appliquées.

Il suffit alors d'activer certains actionneurs pour obtenir le déplacement souhaité.

De manière avantageuse, les bras diamétralement opposés 102.1-102.4, 102.2-12.5, 102.3-102.6 sont actionnés simultanément, ce qui permet d'obtenir un mouvement précis.

Ce dispositif permet d'obtenir des déplacements encore plus précis et mieux contrôlés que ceux obtenus par l'actionneur selon le deuxième mode de réalisation.

On peut prévoir un dispositif dans lequel les bras actionneurs ne comportent que des premiers actionneurs ou que des deuxièmes actionneurs, et de répartir de manière régulière ces bras autour de l'objet à déplacer.

Nous allons maintenant décrire un procédé de réalisation d'un actionneur selon la présente invention.

Le procédé de réalisation comporte les étapes principales :
a) de réalisation d'au moins une électrode fixe en face avant du substrat,
b) de dépôt d'une couche sacrificielle,
c) de structuration de ladite couche sacrificielle pour former au moins une électrode souple, au moins un moyen de suspension et au moins un moyen formant pivot,
d) de dépôt d'une couche conductrice et d'élimination de la couche sacrificielle.

Nous allons décrire de manière détaillée le procédé de réalisation d'un dispositif selon la présente invention.

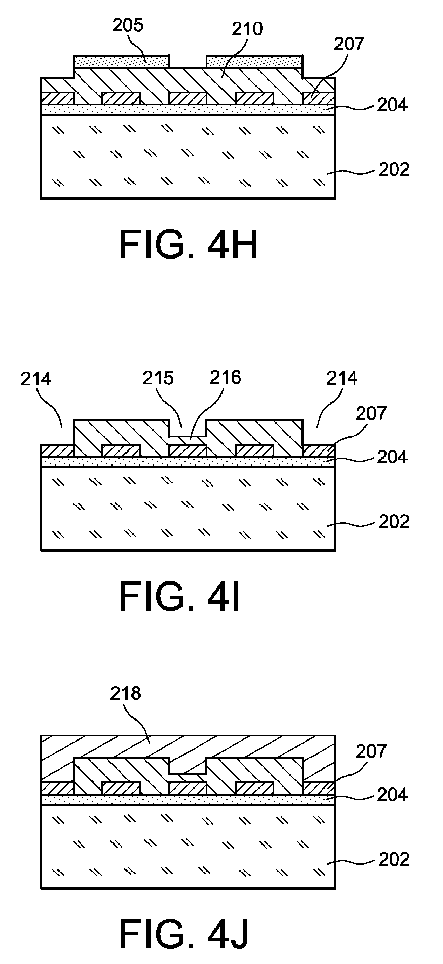

Dans une première étape (Figure 4A), un substrat 202, par exemple du type silicium, est recouvert en face avant d'une couche 204 d'oxyde (SiO2).

Lors d'une deuxième étape (Figure 4B), la couche d'oxyde 204 est recouverte d'une couche conductrice 206, par exemple en métal, tel que l'aluminium, l'or, le cuivre ou le platine ou en polysilicium.

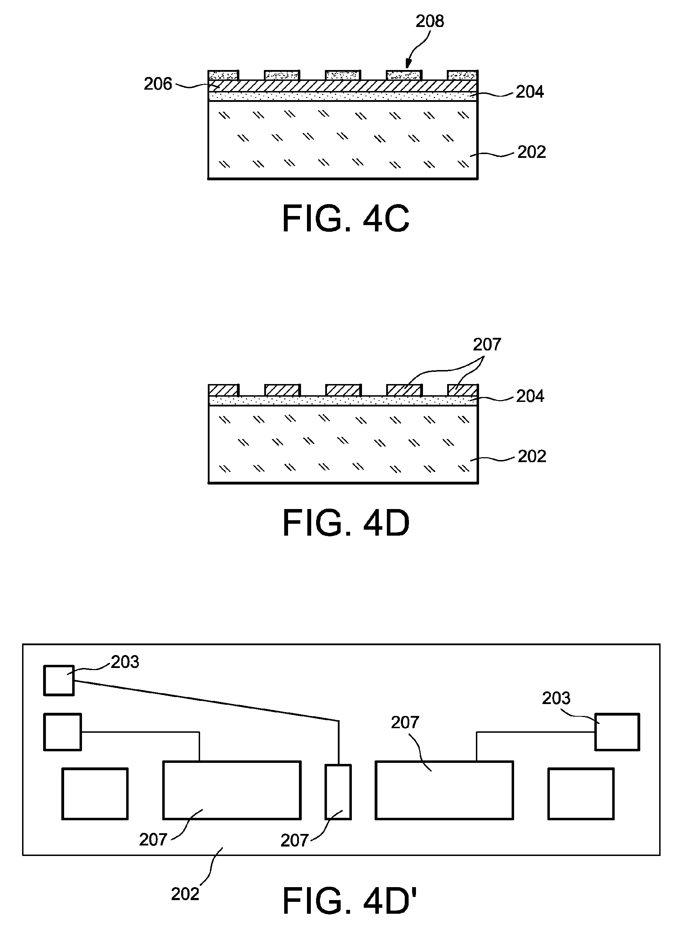

Un masque de lithographie 208 (Figure 4C), en résine, est ensuite formé sur la couche métallique 206, à la suite de quoi la couche métallique 206 est gravée, puis le masque 208 est éliminé.

On obtient ainsi un substrat muni d'une couche d'oxyde sur laquelle sont formées des zones métalliques en forme de bandes 207 parallèles entre elles (Figure 4D), formant les électrodes fixes. Sur la figure 4D', on peut voir le substrat vu de dessus, les électrodes fixes 207 étant, dans l'exemple représenté raccordées à de plots de connexion électrique 203 réalisés ou non simultanément

Une couche de matériau isolant (non représentée) par exemple en SiN ou en SiO₂ est ensuite déposée sur les bandes métalliques.

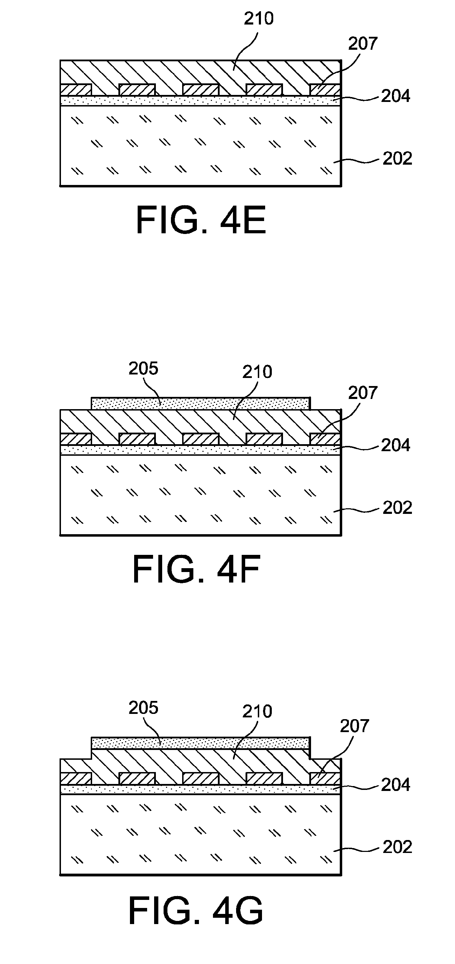

Une couche sacrificielle 210 est ensuite déposée en face avant sur la couche métallique gravée (Figure 4E).

Une couche de résine 205 est ensuite déposée sur la couche sacrificielle et une première lithographie (Figure 4F) est réalisée, de manière à dégager des parties d'extrémité de la couche sacrificielle 210 pour permettre une gravure partielle de celle-ci (Figure 4G).

Une deuxième lithographie est ensuite effectuée sur la couche de résine 205 pour dégager une partie centrale de la couche sacrificielle 210 (Figure 4H).

Une gravure finale de la couche sacrificielle 210 est réalisée de manière à former un canal 215. Des canaux s'étendant perpendiculairement au substrat sont ainsi formés dans la couche sacrificielle 210, les canaux 214 sont traversant et atteignent les bandes métalliques 207. Le canal 214 ménage une couche fine 116 de couche sacrificielle (Figure 4I). La couche sacrificielle est par exemple un oxyde, type SiO₂ ou une résine.

Dans une étape suivante, une couche 218 conductrice est déposée sur la couche sacrificielle. Par exemple du polysilicium. La couche 218 recouvre la couche sacrificielle et remplit les canaux 214 et 215 (Figure 4J).

La couche sacrificielle est ensuite gravée, ainsi la couche silicium polycristallin forme des ponts 220 (Figure 4K). Le pont 220 comporte des premier et deuxième pieds 207 reposant sur le substrat et un troisième pied 209 séparé d'une faible distance du substrat. Le pont forme l'électrode souple 222 et les poutres de suspension 224, les premier et deuxième pieds 207 formant les supports des bras de suspension. Le troisième pied 209 forme le moyen de pivot.

Enfin des moyens de connexions électriques sont réalisés pour les électrodes souples et fixes. Avantageusement ceux-ci sont réalisés pour les électrodes souples en face avant de l'objet à déplacer, et pour les électrodes fixes déposées sur le substrat, directement dans le substrat.

Le procédé selon la présente invention permet de réaliser simultanément un grand nombre de mono-structures telle que cela est représenté sur figure 4J, afin d'obtenir des dispositifs selon les différents modes de réalisation ci-dessus décrits.

Le plot formant le moyen de pivot peut être déposé en même temps que l'électrode souple, ou bien de manière séparée, cependant ceci augmente le temps de réalisation.

Ce procédé permet de réaliser des actionneurs de très faibles dimensions de quelques centaines de µm, permettant un taux d'intégration élevé

A titre indicatif, l'épaisseur des couches peut varier entre 500nm et 2µm.

La présente invention s'applique principalement aux micro-systèmes, notamment aux systèmes Micro-Electro-Mécaniques (MEMS) et en particulier à ceux utilisant un miroir mobile.

## Revendications

1. Actionneur électrostatique comportant :
- au moins une électrode fixe (2) par rapport à un substrat (4),
- au moins une électrode souple (6, 106, 306.1 ,306.3,306.5) disposée en regard du substrat,
- au moins un moyen formant pivot (30,330) de l'électrode souple, ledit moyen étant solidaire de l'électrode souple sur sa face orientée vers l'électrode fixe (2) et réalisé en un matériau conducteur,
- au moins un moyen de suspension (11) de l'électrode souple, maintenant au repos ladite électrode souple à distance du substrat (4), le moyen de suspension (11) et le moyen formant pivot (30, 300) étant distincts.

2. Actionneur selon la revendication 1, dans lequel le moyen de suspension (11) est formé par une poutre de suspension (8,10) fixée par une extrémité à un support (16,18) en saillie du substrat.

3. Actionneur selon l'une des revendications 1 et 2, dans lequel le moyen formant pivot (30,330) a la forme d'un plot.

4. Dispositif selon l'une quelconque des revendications précédentes, dans lequel l'électrode souple s'étend au moins en partie de sa première à sa deuxième extrémités en zigzag.

5. Actionneur selon l'une des revendications 1 à 4, dans lequel une face de l'électrode souple (6) opposée à la face en regard de l'électrode fixe (2), est destinée à supporter un objet à déplacer.

6. Actionneur selon l'une quelconque des revendications 1 à 5, dans lequel l'électrode souple et/ou l'électrode fixe sont recouvertes d'une couche de matériau diélectrique.

7. Actionneur selon l'une des revendications précédentes, comportant deux électrodes fixes (2) et deux moyens formant pivot (30), chacune des électrodes fixes étant disposée entre une extrémité de l'électrode souple et un moyen formant pivot.

8. Dispositif d'actionnement électrostatique, comportant un premier et un deuxième actionneurs (A,B) selon l'une des revendications 1 à 7.

9. Dispositif selon la revendication précédente, dans lequel les électrodes souples (6) des deux actionneurs (A,B) sont suspendues respectivement par le moyen de suspension (11) associé, à un support commun (16) en saillie du substrat (4)

10. Dispositif d'actionnement électrolytique comportant au moins un actionneur du premier type selon l'une des revendications 1 à 7, et au moins un actionneur d'un deuxième type comportant une électrode fixe et une électrode souple (306.2,304.4,306.6) maintenue à distance de l'électrode fixe, lesdits actionneurs étant répartis angulairement de manière régulière.

11. Dispositif selon la revendication précédente, dans lequel les moyens de suspension (11) sont répartis angulairement de manière régulière entre les actionneurs.

12. Dispositif selon la revendication précédente, comportant trois actionneurs du premier type et trois actionneurs du deuxième type en alternance.

13. Dispositif selon la revendication précédente, dans lequel les moyens de suspension sont au nombre de trois répartis angulairement de manière régulière, à angle égal entre un actionneur du premier type et un actionneur du deuxième type.

14. Dispositif selon la revendication 11, dans lequel les actionneurs du premier et deuxième types sont disposés de part et d'autre d'un axe fixé par une extrémité à l'objet à déplacer et formant un moyen de suspension.

15. Dispositif selon la revendication précédente comportant de part et d'autre de l'axe, une pluralité d'actionneurs du premier (102.1,102.2) et deuxième types (104.1,104.2), disposés alternativement parallèlement les uns par rapport aux autres.

16. Dispositif selon la revendication précédente dans lequel les actionneurs adjacents du premier et du deuxième types, sont portés par les branches d'un U, un U disposé d'un côté de l'axe étant raccordé à un U disposé de l'autre côté de l'axe par une branche centrale fixée à l'axe et raccordant les fonds des U.

17. Dispositif selon l'une des revendications 14 à 16, comportant au moins deux axes, avantageusement six axes répartis angulairement de manière régulière autour de l'objet à déplacer.

18. Dispositif selon la revendication 1 à 17, dans lequel les électrodes souples sont munies de zones d'amorce de manière à faciliter le collage des électrodes souples sur le substrat.

19. Microsystème comportant un objet à déplacer et un dispositif d'actionnement électrostatique selon l'une des revendications 8 à 18.

20. Microsystème selon la revendication précédente, dans lequel l'objet à déplacer est un miroir.

21. Procédé de réalisation d'un actionneur électrostatique selon l'une quelconque des revendications 1 à 7 sur un substrat comportant les étapes :
a) de réalisation d'au moins une électrodes fixe en face avant du substrat (202),
b) de dépôt d'une couche sacrificielle (210),
c) de structuration de ladite couche sacrificielle pour former au moins une électrode souple, au moins un moyen de suspension et au moins un moyen formant pivot,
d) de dépôt d'une couche conductrice (218) formant l'électrode souple et le moyen formant pivot et d'élimination de la couche sacrificielle.

22. Procédé selon la revendication précédente, dans lequel, préalablement à la formation de l'électrode fixe, une couche d'oxyde (204), par exemple de l'oxyde de silicium, est déposée en face avant du substrat (202).

23. Procédé selon la revendication 21 ou 22, dans lequel lors de l'étape a), une couche métallique (206) est déposée sur la couche d'oxyde (202), celle-ci étant ensuite structurée par lithographie et gravée.

24. Procédé selon l'une quelconque des revendications 21 à 23, dans lequel un dépôt d'une couche de matériau diélectrique (209) a lieu après la gravure de la couche métallique.

25. Procédé selon l'une des revendications 21 à 24 dans lequel l'étape c) est réalisée par une double lithographie et gravure de la couche sacrificielle.

26. Procédé selon la revendication précédente, à la fin de l'étape c), la couche sacrificielle (210) comporte des canaux (214) traversant, atteignant la couche isolante pour la connexion entre le substrat et l'électrode souple et au moins un canal (215) non traversant pour la formation du moyen formant pivot.
